# FASCICULE DE BREVET EUROPEEN

(11) **EP 4 505 515 B1**
(45) Date de publication et mention de la délivrance du brevet: **25.03.2026**
(21) Numéro de dépôt: 23719826.2
(22) Date de dépôt: 03.04.2023
(51) Int. Cl.: H01L 21/02, H01L 21/18, H01L 21/78, H01L 25/00

(54) **PROCEDE DE FABRICATION D'UNE STRUCTURE COMPRENANT AU MOINS DEUX PUCES SUR UN SUBSTRAT**
VERFAHREN ZUR HERSTELLUNG EINER STRUKTUR MIT MINDESTENS ZWEI CHIPS AUF EINEM SUBSTRAT
METHOD FOR PRODUCING A STRUCTURE COMPRISING AT LEAST TWO CHIPS ON A SUBSTRATE

(30) Priorité: 04.04.2022 FR 2203035
(43) Date de publication de la demande: 12.02.2025
(73) Titulaire: SOITEC, 38190 Bernin (FR)
(72) Inventeur: GHYSELEN, Bruno, 38190 BERNIN (FR)
(74) Mandataire: Regimbeau
(86) Numéro de dépôt international: PCT/FR2023/050472
(87) Numéro de publication internationale: WO 2023/194679

(56) Documents cités:
- WO-A1-2021/050731
- US-A1- 2020 366 064
- US-B1- 9 653 642

## Description

### DOMAINE TECHNIQUE

L'invention concerne un procédé de fabrication d'une structure comprenant au moins deux puces sur un substrat.

### ETAT DE LA TECHNIQUE

Dans le domaine de la microélectronique, de l'optique ou de l'optoélectronique, la conception de structures multicouches nécessite parfois de transférer des pavés se présentant sous forme de portions d'une couche d'un substrat donneur sur un substrat receveur.

Ce type de procédé est généralement appelé procédé de pavage, et met en jeu un transfert partiel d'une couche prélevée dans le substrat donneur pour former un ou plusieurs pavés agencés selon un motif ou à un emplacement prédéterminé sur le substrat receveur.

Un tel pavage peut être rendu nécessaire par une différence de taille entre le substrat donneur et le substrat receveur. En effet, du fait de cette différence de taille, il n'est pas possible de transférer une couche entière du substrat donneur sur le substrat receveur.

Un procédé de transfert de couche bien connu est le procédé Smart Cut^{™}, dans lequel on forme par implantation d'espèces atomiques dans le substrat donneur une zone de fragilisation délimitant la couche à transférer, on colle le substrat donneur sur le substrat receveur et on détache le substrat donneur le long de la zone de fragilisation pour transférer la couche du substrat donneur sur le substrat receveur. Cependant, ce procédé suppose que le substrat donneur et le substrat receveur présentent une taille identique.

Or, si des substrats de silicium sont disponibles avec une taille relativement grande, typiquement un diamètre de 300 mm, d'autres matériaux d'intérêt n'existent actuellement que sous la forme de substrats massifs de plus petite taille, par exemple de 10 ou 15 cm de diamètre. Par ailleurs, ces matériaux d'intérêt sont parfois particulièrement onéreux, de sorte qu'il est souhaitable de minimiser les éventuels déchets formés lors du transfert. Tel est le cas en particulier des matériaux semi-conducteurs III-V, comprenant les nitrures (par exemple pour ce qui est des composés binaires, le nitrure d'indium (InN), le nitrure de gallium (GaN) et le nitrure d'aluminium (AlN)), les arséniures (par exemple pour ce qui est des composés binaires, l'arséniure d'indium (InAs), l'arséniure de gallium (GaAs) et l'arséniure d'aluminium (AlAs)), et les phosphures (par exemple pour ce qui est des composés binaires, le phosphure d'indium (InP), le phosphure de gallium (GaP) et le phosphure d'aluminium (AlP)).

Au lieu de transférer une couche entière du substrat donneur, une solution basée sur le procédé Smart Cut^{™} consiste à former un substrat intermédiaire dit pseudo-donneur, en prélevant d'au moins un substrat donneur un ou plusieurs pavés et en reportant lesdits pavés sur un substrat support présentant un diamètre identique à celui du substrat receveur. Le procédé comprend ensuite la formation par implantation d'espèces atomiques une zone de fragilisation dans chaque pavé, le collage du substrat pseudo-donneur sur le substrat receveur par l'intermédiaire des pavés, et le détachement de chaque pavé le long de la zone de fragilisation de sorte à transférer une portion de chaque pavé sur le substrat receveur.

Au cours du procédé, il est généralement nécessaire de procéder à un polissage des pavés, après la formation du substrat pseudo-donneur et/ou après le transfert des portions de pavés sur le substrat receveur. Un tel polissage, qui est typiquement de type mécano-chimique (CMP, acronyme du terme anglo-saxon « Chemical Mechanical Polishing ») vise à planariser la surface libre des pavés ou portions de pavés.

Une difficulté particulière se pose lorsque le pavage est peu dense, c'est-à-dire que le taux de couverture des pavés sur le substrat receveur, qui correspond au ratio entre la surface totale des pavés et la surface totale du substrat receveur, est typiquement inférieur à 50%, voire inférieur à 30%. Dans cette situation, **il** existe une distance importante, typiquement de l'ordre de quelques millimètres, entre les pavés sur le substrat pseudo-donneur et sur le substrat receveur.

Or, le tissu de polissage qui est appliqué contre les pavés est susceptible de se déformer au niveau des creux formés par les espaces entre les pavés. Cette déformation induit des différences de hauteur de polissage entre pavés et une surconsommation de matière sur les bords des pavés par rapport à leur centre.

Ces inhomogénéités générées par le polissage pénalisent l'utilisation ultérieure des pavés pour former des composants électroniques, optiques ou opto-électroniques.

US 2020/366064 A1 divulgue un procédé de fabrication d'une structure comprenant au moins deux puces sur un substrat receveur.

### BREVE DESCRIPTION DE L'INVENTION

Un but de l'invention est de concevoir un procédé de fabrication d'une structure comprenant au moins deux puces sur un substrat support, qui permette de remédier aux défauts de polissage susmentionnés.

A cet effet, l'invention propose un procédé de fabrication d'une structure comprenant au moins deux puces sur un substrat receveur, comprenant :
- la formation d'un substrat pseudo-donneur par placement d'au moins un pavé d'au moins un substrat donneur sur un substrat support ;
- le collage dudit substrat pseudo-donneur sur un substrat receveur par l'intermédiaire des pavés de sorte que chaque pavé recouvre au moins partiellement au moins deux zones d'intérêt distinctes du substrat receveur ;
- le transfert d'une portion desdits pavés sur le substrat receveur ;
- au moins une étape de polissage mécano-chimique des pavés du substrat pseudo-donneur et/ou des portions de pavés transférées sur le substrat receveur ;
- après ladite au moins une étape de polissage mécano-chimique, un enlèvement de matière desdites portions de pavés de sorte à diviser chaque portion de pavé en au moins deux puces agencées chacune sur une zone d'intérêt respective.

Le fait de redimensionner les portions de pavés après leur transfert sur le substrat receveur pour former les puces permet d'augmenter la densité des pavés sur le substrat pseudo-donneur et de réduire les distances, entre pavés et, après le transfert, entre portions de pavés. De ce fait, les défauts de polissage liés à des distances trop importantes entre les pavés ou entre les portions de pavés transférées sont minimisés.

Après l'étape de gravure, le taux de couverture des puces sur le substrat receveur, c'est-à-dire le ratio entre la surface totale des puces et la surface totale du substrat receveur, est avantageusement inférieur à 50%, de préférence inférieur à 30%.

De manière particulièrement avantageuse, le taux de couverture des pavés sur le substrat pseudo-donneur, c'est-à-dire le ratio entre la surface totale des pavés et la surface totale du substrat support, est supérieur à 50%, de préférence supérieur à 75%.

Chaque pavé peut présenter un côté de longueur supérieure ou égale à 5 mm, de préférence supérieure ou égale à 8 mm, et de manière préférée supérieure ou égale à 10 mm.

Par ailleurs, chaque puce peut présenter un côté de longueur inférieure ou égale à 5 mm, de préférence inférieure ou égale à 3 mm, et de manière préférée inférieure ou égale à 1 mm.

De manière particulièrement avantageuse, la distance entre deux pavés adjacents est inférieure ou égale à 3 mm, de préférence inférieure ou égale à 1 mm.

La distance entre deux puces adjacentes peut en revanche être supérieure ou égale à 3 mm, de préférence supérieure ou égale à 5 mm.

Dans certains modes de réalisation, chaque pavé recouvre au moins partiellement deux zones d'intérêt distinctes du substrat receveur et on forme, à partir dudit pavé, une puce sur chaque zone d'intérêt respective.

Dans d'autres modes de réalisation, chaque pavé recouvre un coin respectif de quatre zones d'intérêt distinctes du substrat receveur agencées en carré ou en rectangle, et on forme, à partir dudit pavé, une puce sur chaque coin de la zone d'intérêt respective.

Dans d'autres modes de réalisation, chaque pavé se présente sous la forme d'une bande recouvrant au moins partiellement au moins trois zones d'intérêt alignées du substrat receveur et on forme, à partir dudit pavé, une puce sur chaque zone d'intérêt respective.

De manière particulièrement avantageuse, le substrat support et le substrat receveur présentent un diamètre sensiblement identique, supérieur au diamètre du substrat donneur.

Le collage du substrat pseudo-donneur sur le substrat receveur peut être réalisé par adhésion moléculaire.

Dans une forme d'exécution préférée, le transfert de chaque portion de pavé comprend successivement la formation d'une zone de fragilisation par implantation d'espèces atomiques dans chaque pavé du substrat pseudo-donneur pour définir une portion de pavé à transférer, le collage du substrat pseudo-donneur sur le substrat receveur par l'intermédiaire des pavés, et le détachement de chaque pavé le long de la zone de fragilisation.

Dans d'autres formes d'exécution, le transfert de chaque portion de pavé comprend un amincissement par meulage et/ou gravure de chaque pavé du substrat pseudo-donneur.

Chaque pavé peut présenter une épaisseur comprise entre 20 µm et 1000 µm, de préférence comprise entre 100 µm et 700 µm, et la portion transférée de chaque pavé peut présenter une épaisseur comprise entre 30 nm et 1,5 µm.

Chaque pavé peut comprendre :
- un matériau semi-conducteur, tel qu'un matériau III-V, notamment le nitrure d'indium (InN), le nitrure de gallium (GaN), le nitrure d'aluminium (AIN), l'arséniure d'indium (InAs), l'arséniure de gallium (GaAs), l'arséniure d'aluminium (AlAs), le phosphure d'indium (InP), le phosphure de gallium (GaP) ou le phosphure d'aluminium (AlP), ou un matériau IV ou IV-IV, notamment le germanium ou le carbure de silicium (SiC),
- un matériau piézoélectrique, tel que le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN), et/ou
- un matériau électriquement isolant, tel que le diamant, le titanate de strontium, la zircone yttriée ou le saphir.

Dans certaines formes d'exécution, le procédé comprend une étape de formation par épitaxie d'au moins une couche épitaxiale sur chaque portion de pavé, l'enlèvement de matière pour diviser chaque portion de pavé en puces étant mis en oeuvre après ladite étape d'épitaxie.

Dans certains modes de réalisation, l'enlèvement de matière comprend :
- la formation d'un masque comprenant un film protecteur recouvrant en partie lesdites portions de pavés selon un motif définissant lesdites puces dans chaque portion de pavé et au moins une ouverture définissant un espace à former entre deux puces ;
- la gravure de chaque portion de pavé au travers de chaque ouverture du masque de sorte à former ledit espace pour séparer lesdites puces les unes des autres.

La gravure peut être réalisée au moyen d'une solution de gravure et le masque est formé d'une résine photosensible.

De manière alternative, la gravure peut être réalisée au moyen d'un faisceau d'ions et le masque est formé d'un métal.

Dans d'autres modes de réalisation, l'enlèvement de matière est réalisé de manière sélective par un faisceau focalisé d'ions, ledit faisceau étant contrôlé pour balayer uniquement les régions des portions de pavés à enlever.

### BREVE DESCRIPTION DES FIGURES

D'autres caractéristiques et avantages de l'invention ressortiront de la description détaillée qui va suivre, en référence aux dessins annexés, sur lesquels :
- la figure 1 est une vue de dessus du substrat receveur sur lequel les zones d'intérêt sont schématisées,
- la figure 2 illustre une étape de prélèvement de pavés d'un substrat donneur,
- la figure 3 illustre une étape de placement desdits pavés sur un substrat support pour former un substrat pseudo-donneur,
- la figure 4 illustre une étape de formation d'une zone de fragilisation dans lesdits pavés,
- la figure 5 illustre une étape de collage du substrat pseudo-donneur sur un substrat receveur par l'intermédiaire des pavés,
- la figure 6 illustre une étape de transfert des portions de pavés sur le second substrat support suite au détachement des pavés le long de la zone de fragilisation,
- la figure 7 illustre une étape de formation d'un masque sur les portions de pavés de sorte à délimiter les puces à former,
- la figure 8 illustre une étape de gravure des zones des pavés non protégées par le masque pour former les puces,
- la figure 9 illustre une étape de retrait du film protecteur après la gravure,
- la figure 10A illustre un mode de réalisation dans lequel chaque pavé recouvre en partie deux zones d'intérêt adjacentes, et la figure 10B illustre un exemple de répartition des puces formées à partir desdits pavés,
- la figure 11A illustre un mode de réalisation dans lequel chaque pavé recouvre en partie plusieurs zones d'intérêt alignées, et la figure 11B illustre un exemple de répartition des puces formées à partir desdits pavés,
- la figure 12A illustre un mode de réalisation dans lequel chaque pavé recouvre en partie quatre zones d'intérêt agencées en carré, et la figure 12B illustre un exemple de répartition des puces formées à partir desdits pavés.

Pour des raisons de lisibilité, les dessins ne sont pas nécessairement réalisés à l'échelle. Par ailleurs, le nombre et la forme des zones d'intérêt, des pavés et des puces schématisés sur les dessins n'est donné qu'à titre d'illustration.

### DESCRIPTION DETAILLEE DE MODES DE REALISATION

L'invention propose de former une structure comprenant au moins deux puces sur un substrat receveur, dans laquelle on évite les inhomogénéités de polissage même dans le cas où les puces sont espacées d'une distance relativement grande, et/ou réparties de manière peu dense sur le substrat receveur, en utilisant un substrat dit pseudo-donneur comprenant des pavés destinés à former chacun au moins deux puces, lesdites puces étant réparties sur au moins deux zones d'intérêt distinctes du substrat receveur. Le substrat pseudo-donneur est collé sur le substrat receveur par l'intermédiaire des pavés, de sorte à transférer une portion des pavés sur le substrat receveur. Puis, un enlèvement de matière sur chaque pavé, notamment entre les puces, permet de former chaque puce.

Par peu dense, on entend dans le présent texte que le taux de couverture des puces sur le substrat receveur, qui correspond au ratio entre la surface totale des puces et la surface totale du substrat receveur, est typiquement inférieur à 50%, voire inférieur à 30%, et/ou que la distance entre deux puces adjacentes est supérieure ou égale à 3 mm, voire supérieure ou égale à 5 mm.

Par zone d'intérêt, on entend dans le présent texte une zone du substrat receveur destinée à former ultérieurement un circuit électronique distinct du circuit électronique formé dans une zone adjacente. En particulier, dans une étape ultérieure de fabrication desdits circuits électroniques, le substrat receveur peut être découpé pour former des puces individuelles.

Les zones d'intérêt ne sont pas nécessairement visibles sur le substrat receveur ; elles peuvent en particulier être définies sur un plan indiquant l'emplacement de chaque composant sur le substrat receveur à chaque étape du procédé de fabrication. L'emplacement des zones d'intérêt sur le substrat receveur est mis en relation avec ledit plan grâce à un référentiel du substrat receveur, c'est-à-dire un système de coordonnées attaché au substrat receveur, et qui permet de définir la position de chaque point de la surface du substrat receveur. Par exemple, ledit référentiel peut comprendre un point d'origine repérable sur un bord du substrat receveur, tel qu'une encoche classiquement utilisée dans l'industrie des semi-conducteurs, et deux axes orthogonaux s'étendant dans le plan du substrat, l'un des axes s'étendant diamétralement à partir de l'encoche et l'autre axe coupant le premier axe au centre du substrat.

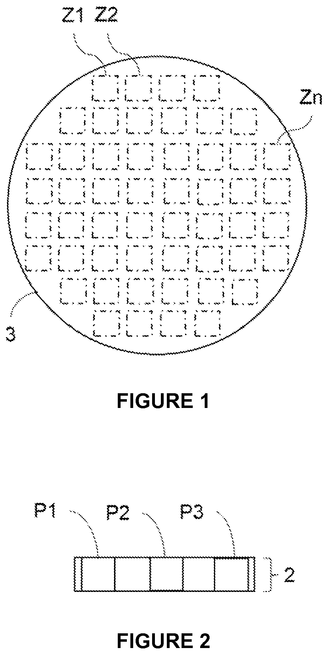

La figure 1 illustre un exemple de répartition des zones d'intérêt sur un substrat receveur. Le substrat receveur 3 présente une pluralité de zones d'intérêt Z1, Z2, Zn (n étant un nombre entier compris entre 1 et le nombre total de zones d'intérêt) délimitées par des pointillés. Ces zones ne sont pas nécessairement matérialisées sur la surface du substrat receveur mais l'emplacement de chaque zone d'intérêt dans un référentiel du substrat receveur est connu.

Dans l'exemple illustré sur la figure 1, les zones d'intérêt présentent toutes une forme rectangulaire identique et sont agencées sur le substrat receveur selon des lignes et des colonnes pour former un quadrillage. Cependant, dans d'autres modes de réalisation non illustrés, les zones d'intérêt peuvent présenter des dimensions et/ou des formes différentes.

Le procédé de transfert implique au moins un polissage mécano-chimique des pavés. Un tel polissage peut être effectué après la mise en place des pavés sur le substrat support pour former le substrat pseudo-donneur, avant collage au substrat receveur, sur les portions de pavés transférées sur le substrat receveur, voire à la fois sur les pavés du substrat pseudo-donneur et sur les portions de pavés transférées sur le substrat receveur.

Le fait que les pavés soient dimensionnés pour former au moins deux puces permet d'augmenter le taux de couverture des pavés et/ou de diminuer la distance entre pavés sur le substrat pseudo-donneur par rapport respectivement au taux de couverture des puces sur le substrat receveur, et la distanciation entre puces.

Ainsi, le taux de couverture des pavés sur le substrat pseudo-donneur, c'est-à-dire le ratio entre la surface totale des pavés et la surface totale du substrat support, est avantageusement supérieur à 50%, de préférence supérieur à 75%. Le substrat receveur peut présenter un diamètre sensiblement identique à celui du substrat support. Dans ce cas, ce taux de couverture sera également celui des portions de pavés transférées sur le substrat receveur.

De manière avantageuse, la distance entre deux pavés adjacents est inférieure ou égale à 3 mm, de préférence inférieure ou égale à 1 mm.

Par ailleurs, les substrat pseudo-donneur et receveur peuvent avoir la forme d'un disque assez fin ayant typiquement quelques centaines de µm d'épaisseur (appelé communément « tranche » dans le domaine de la microélectronique) ou une forme rectangulaire ou n'importe quelle forme géométrique.

Par conséquent, les pavés (et les portions de pavés transférées) sont avantageusement répartis de manière suffisamment dense pour que le polissage mécano-chimique ne produise pas d'inhomogénéités d'épaisseur entre pavés ou portions de pavés transférées. En effet, la déformation du tissu de polissage entre pavés adjacents est minimisée, de sorte que le polissage est sensiblement uniforme sur toute la surface des pavés ou portions de pavés.

Ce n'est qu'après cette étape de polissage que les puces sont formées par enlèvement de matière des portions de pavés transférées sur le substrat receveur. Cet enlèvement de matière conduit à une réduction de la densité des puces par rapport à celle des pavés mais, dans la mesure où aucune étape de polissage mécano-chimique des puces ne doit plus être effectuée, elle n'induit pas de risque de perte d'homogénéité de l'épaisseur et de la forme des puces.

L'enlèvement de matière peut être réalisé par différentes techniques, qui sont connues en elles-mêmes.

Certaines techniques utilisent un masque pour protéger la surface des puces et exposer la surface des portions de pavés destinée à être retirée par application d'un agent de gravure.

De manière particulièrement avantageuse, le masque est formé par photolithographie, le film protecteur étant alors formé d'une résine photosensible résistant à l'agent de gravure qui est une composition de gravure chimique. La photolithographie étant très précise, elle permet donc de garantir que les puces présentent la forme et la position souhaitées.

De manière alternative, l'agent de gravure est un faisceau d'ions (technique connue sous le terme anglo-saxon de « sputtering »). Le masque peut comprendre un film protecteur métallique ou une résine photosensible, qui protège le matériau des pavés du faisceau d'ions dans les zones recouvertes par le film protecteur.

Le masque est retiré après que les portions de pavés ont été gravées sur tout ou partie de leur épaisseur.

On notera qu'il est possible de s'affranchir de l'utilisation d'un masque si l'on utilise un procédé de gravure sélective mettant en oeuvre un faisceau focalisé d'ions de gravure contrôlé pour balayer uniquement les zones des portions de pavés à éliminer.

Le substrat pseudo-donneur peut être réalisé en plaçant les pavés un par un, ou par petits groupes de pavés, sur le substrat support, par exemple par le procédé de « Pick and Place » ; en revanche, le transfert des pavés du substrat pseudo-donneur sur le substrat receveur peut être réalisé simultanément.

Le procédé permet donc de subdiviser un pavé en plusieurs puces plus petites, s'étendant sur plusieurs zones d'intérêt distinctes, de préférence adjacentes. Le procédé présente ainsi l'avantage de former des puces de très petites dimensions sans avoir à les placer individuellement sur le substrat receveur, et en s'affranchissant des problèmes d'inhomogénéités dues au polissage mécano-chimique si les puces sont peu densément réparties.

Par exemple, chaque pavé présente initialement un côté de longueur supérieure ou égale à 5 mm, de préférence supérieure ou égale à 8 mm, et de manière préférée supérieure ou égale à 10 mm.

De manière avantageuse, les pavés sont en un matériau qui n'est pas disponible commercialement sous forme de substrat donneur de grandes dimensions. Ainsi, le substrat donneur peut présenter un diamètre inférieur à 30 cm, par exemple de l'ordre de 10 ou 15 cm.

Tel est le cas en particulier des matériaux semi-conducteurs III-V, comprenant les nitrures (par exemple pour ce qui est des composés binaires, le nitrure d'indium (InN), le nitrure de gallium (GaN) et le nitrure d'aluminium (AlN)), les arséniures (par exemple pour ce qui est des composés binaires, l'arséniure d'indium (InAs), l'arséniure de gallium (GaAs) et l'arséniure d'aluminium (AlAs)), et les phosphures (par exemple pour ce qui est des composés binaires, le phosphure d'indium (InP), le phosphure de gallium (GaP) et le phosphure d'aluminium (AlP)).

Ceci est le cas aussi pour des composés semi-conducteurs IV ou IV-IV, comme par exemple le germanium et le carbure de silicium.

Les pavés peuvent également être en un matériau piézoélectrique, par exemple le tantalate de lithium (LiTaO₃) ou encore le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AlScN) (liste non limitative).

Les pavés peuvent également être en un matériau électriquement isolant, tel que par exemple le diamant, le titanate de strontium (SrTiO₃), la zircone yttriée (YSZ), ou encore le saphir.

Les figures 2 à 9 illustrent de manière schématique la formation d'un substrat pseudo-donneur comprenant les pavés placés sur un premier substrat support et le transfert des portions de pavés sur un substrat receveur, puis la division de chaque portion de pavé en au moins deux puces.

En référence à la figure 2, on découpe des pavés P1-P3 d'un substrat donneur 2. La découpe des pavés peut être réalisée par toute technique connue de l'homme du métier. Elle peut notamment être réalisée par sciage et/ou clivage, ou encore par découpe laser. Elle peut aussi par exemple être combinée avec une étape de gravure partielle par plasma des traits de découpe, technique connue sous le terme anglais de « plasma dicing ».

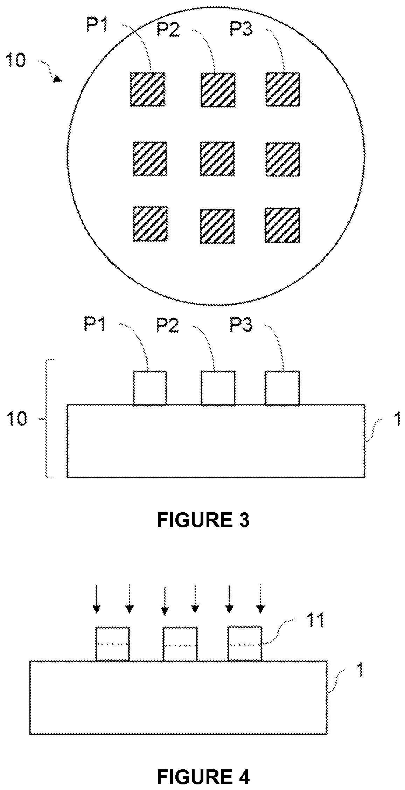

La figure 3 illustre le placement des pavés prélevés du substrat donneur de la figure 2 sur un substrat support 1 pour former un substrat pseudo-donneur 10.

Le placement peut être mis en oeuvre par la technique de « Pick and Place », par laquelle un robot saisit un pavé, ou un groupe de pavés, préalablement découpé dans le substrat donneur et le place à un emplacement prédéterminé sur le substrat support.

Dans certains modes de réalisation, chaque pavé adhère au substrat support par adhésion moléculaire. A cet effet, des traitements de surface des pavés et/ou du substrat support peuvent être mis en oeuvre au préalable afin de favoriser une bonne adhésion moléculaire. Ces traitements peuvent comprendre notamment un nettoyage, le dépôt d'une couche de collage tel qu'un oxyde de silicium (SiO₂), une activation par plasma avant collage et un recuit.

Dans d'autres modes de réalisation (non illustrés), le collage des pavés au substrat support peut faire intervenir une couche de collage intermédiaire, par exemple une couche de collage polymère, une couche de collage eutectique ou une couche de colle céramique.

Le substrat support 1 présente avantageusement un diamètre ou des dimensions supérieures à celles du substrat donneur 2. Par exemple le substrat support 1 peut avoir la forme d'un disque ayant un diamètre de l'ordre de 300 mm.

La figure 4 illustre la formation d'une zone de fragilisation dans lesdits pavés P1-P3 afin de délimiter une portion superficielle desdits pavés destinée à être transférée sur un substrat receveur. Comme schématisé par les flèches, la zone de fragilisation 11 est avantageusement formée par implantation d'espèces atomiques, telles que de l'hydrogène et/ou de l'hélium, dans les pavés, à une profondeur correspondant à l'épaisseur de la couche à transférer.

Eventuellement, le substrat pseudo-donneur peut faire l'objet d'un polissage mécano-chimique de la surface des pavés.

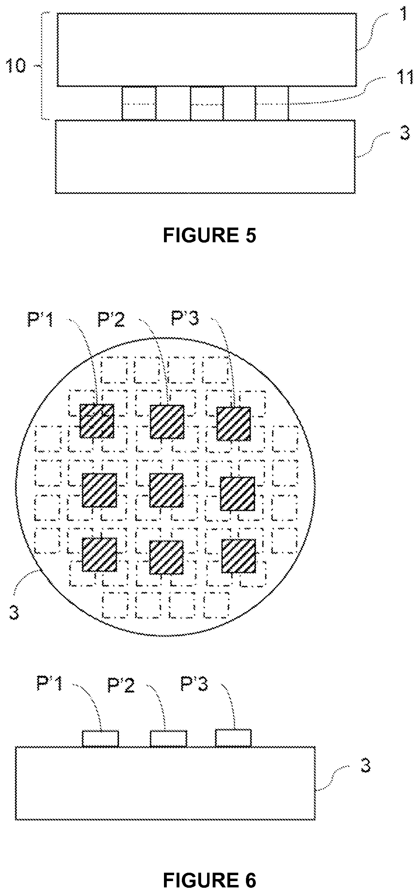

La figure 5 illustre le collage du substrat pseudo-donneur de la figure 3 sur un substrat receveur par l'intermédiaire des pavés.

Lors de ce collage, on positionne les deux substrats l'un par rapport à l'autre de telle sorte que chaque pavé du substrat pseudo-donneur 10 recouvre au moins partiellement au moins deux zones d'intérêt distinctes du substrat receveur 3.

Dans l'exemple illustré, chaque pavé recouvre partiellement quatre zones d'intérêt agencées en carré ou en rectangle, c'est-à-dire que les quatre zones d'intérêt appartiennent à deux lignes et à deux colonnes adjacentes, les centres des quatre zones d'intérêt formant les quatre sommets d'un carré ou d'un rectangle. Chaque pavé recouvre donc non seulement une partie de la surface desdites zones d'intérêt mais aussi la surface du substrat receveur située entre les zones d'intérêt, qui présente, dans cet exemple, une forme de croix. En général, afin d'optimiser la surface du substrat receveur et minimiser les pertes de matière, la distance entre zones d'intérêt est minimisée. La surface de chaque zone d'intérêt recouverte par le pavé est adaptée en fonction de la taille des composants à former dans ou sur la puce ou la zone d'intérêt.

De manière particulièrement avantageuse, chaque pavé adhère au substrat receveur 3 par adhésion moléculaire. A cet effet, des traitements de surface des pavés et/ou du substrat receveur peuvent être mis en œuvre au préalable afin de favoriser une bonne adhésion moléculaire. Ces traitements peuvent comprendre notamment un nettoyage, le dépôt d'une couche de collage tel qu'un oxyde de silicium (SiO₂), une activation plasma avant collage, un polissage et un recuit, préférentiellement à basse température (c'est-à-dire typiquement en dessous de 300°C).

Le substrat support 1 et le substrat receveur 3 présentent avantageusement un diamètre sensiblement identique, par exemple de l'ordre de 300 mm.

Ensuite, en référence à la figure 6, les pavés sont détachés le long de la zone de fragilisation 11, afin de transférer les portions P'1, P'2, P'3 délimitées par ladite zone de fragilisation sur le substrat receveur.

Les pavés placés sur le substrat support présentent typiquement une épaisseur comprise entre 20 µm et 1000 µm, de préférence comprise entre 100 µm et 700 µm. La portion transférée de chaque pavé présente généralement une épaisseur comprise entre 30 nm et 1,5 µm.

Selon une alternative au procédé Smart Cut^{™} qui vient d'être décrit, les portions de pavés peuvent être obtenues par amincissement par meulage et/ou gravure de chaque pavé du substrat pseudo-donneur après collage du substrat pseudo-donneur sur le substrat receveur. Cependant, un avantage du procédé Smart Cut^{™} est de minimiser la perte de matière, le substrat pseudo-donneur pouvant éventuellement être recyclé et utilisé pour transférer à nouveau des portions de pavés sur le même substrat receveur ou sur un autre substrat receveur.

Eventuellement, après le transfert desdites portions de pavés sur le substrat receveur, on peut mettre en oeuvre un polissage mécano-chimique de la surface des portions de pavés.

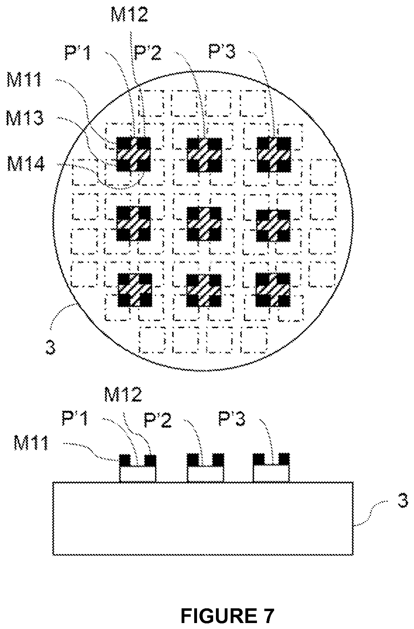

La figure 7 illustre la formation, par exemple par photolithographie, d'un masque comprenant un film protecteur M11, M12, M13, M14 recouvrant partiellement chaque portion de pavé et des ouvertures s'étendant entre les portions de film protecteur.

Le film protecteur est configuré pour définir un motif correspondant à la géométrie et à l'emplacement de chaque puce sur chaque zone d'intérêt respective.

Les ouvertures correspondent typiquement à la surface du substrat receveur située entre les zones d'intérêt. Ainsi, dans l'exemple illustré, les ouvertures sont en forme de croix et délimitent quatre portions rectangulaires M11-M14 du film protecteur sur chaque portion de pavé.

Selon un mode de réalisation, le film protecteur ne s'étend pas jusqu'aux bords de la portion de pavé situés dans la zone d'intérêt. Cela permet, dans l'étape de gravure suivante, de retirer également une région périphérique des portions de pavé, par exemple pour redimensionner ladite portion. Cependant, dans un souci de minimiser la perte de matière, les pavés sont de préférence dimensionnés pour minimiser la région périphérique à retirer.

Le film peut être constitué de toute résine appropriée. En particulier dans le domaine de la microélectronique, de telles résines photosensibles, commercialisées par exemple par les sociétés Shipley ou encore AZ Electronic Materials, sont dispensées à l'état visqueux et étalées sur les substrats à l'aide de tournettes (opération de « spin coating » selon la terminologie anglo-saxonne) puis recuites. Une étape d'insolation UV permet après révélation de garder ou au contraire supprimer les zones exposées. Selon une variante connue sous le nom anglo-saxon de « dry film photo resist », l'application de ces résines peut également se faire par lamination d'un film épais, d'épaisseur typiquement comprise entre 15 et 50 µm, fourni sous forme de rouleaux.

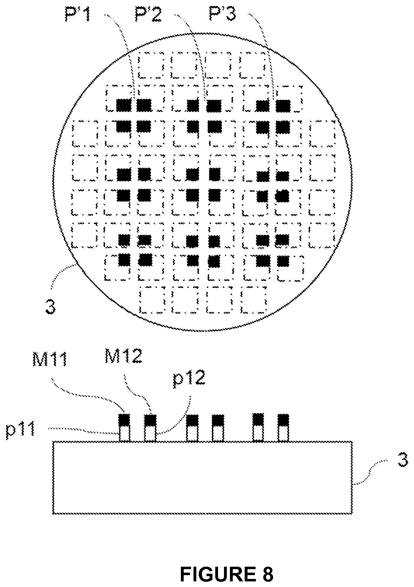

En référence à la figure 8, on applique une solution de gravure sur la structure de la figure 7. La composition de la solution de gravure est choisie en fonction du matériau des pavés. Par exemple, dans le cas où les pavés sont en InP, il pourra être fait appel à une gravure humide dans un bain d'acide chlorhydrique (HCl) et d'acide phosphorique (H₃PO₄). On pourra aussi utiliser une gravure plasma sur la base de gaz halogénés (à base de chlore par exemple ou de mélanges méthane/di-hydrogène (CH₄/H₂).

De manière avantageuse, la solution de gravure n'attaque pas ou peu le matériau du substrat receveur 3.

De manière alternative, une gravure par pulvérisation (« sputtering ») sous faisceau d'ions, d'argon par exemple, peut aussi être utilisée. Dans ce cas, le film protecteur est avantageusement métallique.

A l'issue de la gravure, la partie des pavés non recouverte par le film protecteur a été retirée, sur tout ou partie de l'épaisseur des pavés, pour séparer les puces.

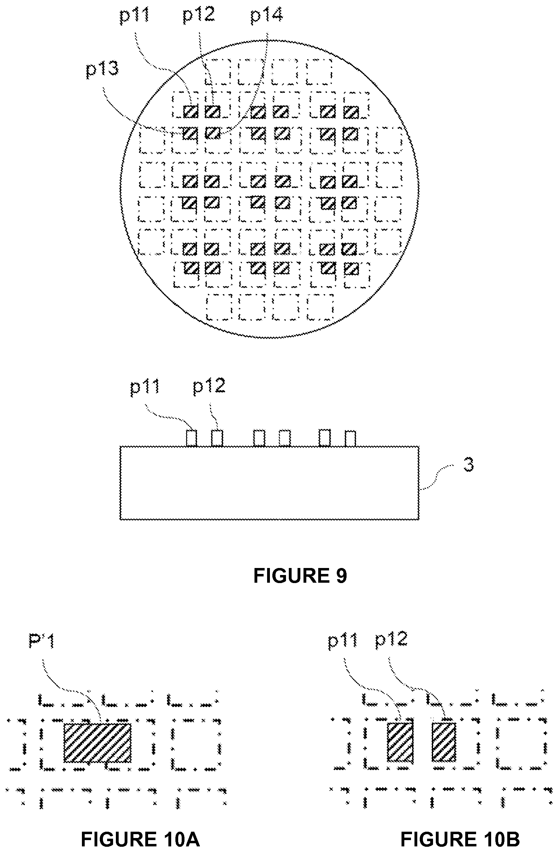

En référence à la figure 9, on retire le film protecteur de sorte à libérer la surface des puces. La structure est donc prête pour les étapes de fabrication ultérieures, par exemple un dépôt ou une épitaxie d'une ou plusieurs couches additionnelles sur les puces, la formation de composants électroniques dans ou sur les puces, la découpe du substrat receveur pour séparer les puces, etc.

On notera que, après la formation des puces, aucun polissage mécano-chimique n'est mis en oeuvre afin de ne pas créer d'inhomogénéité au sein des puces. En d'autres termes, toute étape de polissage mécano-chimique est réalisée soit sur le substrat pseudo-donneur, soit sur le substrat receveur après le transfert des portions de pavés, mais avant l'enlèvement de matière conduisant à l'obtention des puces. Ainsi, le polissage mécano-chimique est réalisé dans tous les cas sur les pavés ou portions de pavés, qui présentent de relativement grandes dimensions, supérieures à la dimension nécessaire à la réalisation des puces visées. Plus précisément, chaque pavé présente une dimension supérieure à un multiple de la dimension des puces ciblée dans le procédé de fabrication. Par exemple, chaque pavé peut présenter une dimension deux ou quatre fois supérieure à la dimension ciblée.

De multiples géométries peuvent être obtenues selon la destination de la structure finale et l'agencement des zones d'intérêt.

Dans certains modes de réalisation, chaque pavé recouvre au moins partiellement deux zones d'intérêt distinctes du substrat receveur et on forme, à partir dudit pavé, une puce sur chaque zone d'intérêt respective.

Par exemple, comme illustré sur la figure 10A, chaque pavé et portion de pavé transférée P'1 peut être agencé de sorte à recouvrir une partie de deux zones d'intérêt adjacentes ainsi que la surface du substrat receveur entre lesdites zones d'intérêt. L'enlèvement de matière peut être réalisé de sorte à retirer le matériau de chaque portion de pavé en regard de la surface séparant les zones d'intérêt, et, le cas échéant, le matériau de chaque portion de pavé en regard de chaque zone d'intérêt pour respecter la géométrie souhaitée pour chaque puce p11, p12 (cf. figure 10B).

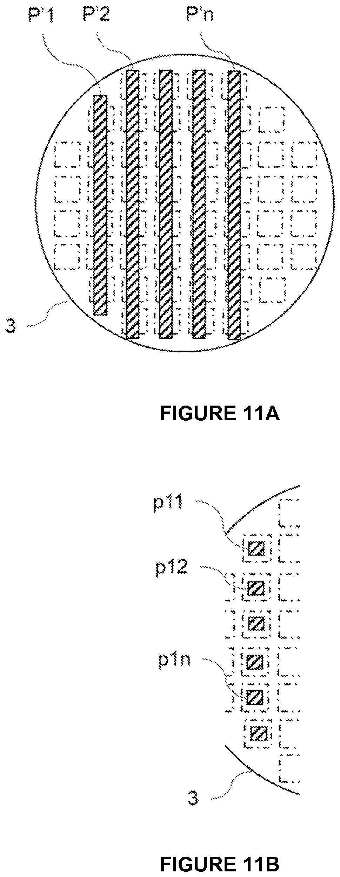

Selon un autre exemple, illustré sur la figure 11A, chaque pavé et portion de pavé transférée P'1, P'2, P'n peut se présenter sous la forme d'une bande allongée recouvrant partiellement une pluralité de zones d'intérêt alignées. On peut alors former une ou plusieurs puces p11, p12, p1n alignées dans chacune des zones d'intérêt appartenant à une même ligne ou colonne (cf. figure 11B).

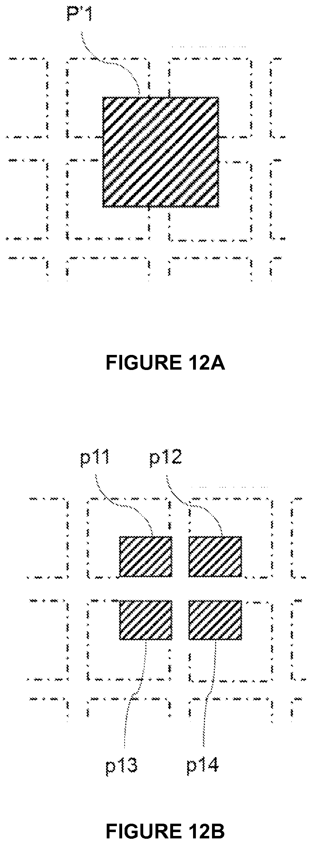

Dans d'autres modes de réalisation, comme illustré sur la figure 12A, qui est un agrandissement de la figure 5, chaque pavé et portion de pavé transférée P'1 peut être agencé de sorte à recouvrir un coin respectif de quatre zones d'intérêt distinctes du substrat receveur agencées en carré, et on forme, à partir dudit pavé, une puce p11, p12, p13, p14 sur chaque coin de la zone d'intérêt respective (cf. figure 12B).

Naturellement, ces différentes configurations peuvent être combinées. Par exemple, il est possible de transférer des portions de pavés orientées différemment (par exemple perpendiculaires deux à deux) selon les zones d'intérêt à recouvrir.

Le procédé offre donc une grande latitude pour la formation des puces en fonction des composants à y former.

### Exemples d'applications

La présente invention présente différents cas d'applications particulièrement avantageux, notamment dans le domaine de la microélectronique.

Le procédé peut permettre de disposer des puces de manière peu dense sur un substrat receveur de 300 mm de diamètre. Ledit substrat receveur peut être un substrat de silicium ou un substrat de type silicium sur isolant (SOI, acronyme du terme anglo-saxon « Silicon On Insulator »).

Dans des applications photoniques, la couche active du substrat receveur peut comprendre un circuit photonique comportant des dispositifs passifs ou actifs, par exemple un ou plusieurs guide(s) d'onde, un ou plusieurs multiplexeur(s), un ou plusieurs micro-résonateurs, etc. Les puces transférés sur cette couche peuvent être en InP, qui est un matériau plus adapté que le silicium pour la croissance épitaxiale d'un empilement de matériaux III-V permettant de former un laser.

Dans des applications radiofréquences (RF), la couche active du substrat receveur peut comprendre des composants fonctionnant à relativement basse fréquence, tandis que les puces, qui sont avantageusement réalisés en InP ou en GaN, peuvent comprendre les composants fonctionnant aux plus hautes fréquences.

Dans des applications micro-LEDs, la taille des puces de GaN est avantageusement inférieure à 50 µm.

## Revendications

1. Procédé de fabrication d'une structure comprenant au moins deux puces (p11, p12, p13, p14) sur un substrat receveur (3), comprenant :
- la formation d'un substrat pseudo-donneur (10) par placement d'au moins un pavé (P1, P2, P3) d'au moins un substrat donneur (2) sur un substrat support (1) ;
- le collage dudit substrat pseudo-donneur (10) sur un substrat receveur (3) par l'intermédiaire des pavés de sorte que chaque pavé recouvre au moins partiellement au moins deux zones d'intérêt distinctes (Z1, Z2, Zn) du substrat receveur (3) ;
- le transfert d'une portion (P'1, P'2, P'3) desdits pavés (P1, P2, P3) sur le substrat receveur (3) ;
- au moins une étape de polissage mécano-chimique des pavés (P1, P2, P3) du substrat pseudo-donneur et/ou des portions de pavés transférées sur le substrat receveur ;
- après ladite au moins une étape de polissage mécano-chimique, un enlèvement de matière desdites portions (P'1, P'2, P'3) de pavés de sorte à diviser chaque portion de pavé en au moins deux puces (p11, p12, p13, p14) agencées chacune sur une zone d'intérêt (Z1, Z2, Zn) respective.

2. Procédé selon la revendication 1, dans lequel, après l'étape de gravure, le taux de couverture des puces (p11, p12, p13, p14) sur le substrat receveur (3), c'est-à-dire le ratio entre la surface totale des puces et la surface totale du substrat receveur, est inférieur à 50%, de préférence inférieur à 30%.

3. Procédé selon l'une des revendications 1 ou 2, dans lequel le taux de couverture des pavés (P1, P2, P3) sur le substrat pseudo-donneur (10), c'est-à-dire le ratio entre la surface totale des pavés et la surface totale du substrat support, est supérieur à 50%, de préférence supérieur à 75%.

4. Procédé selon l'une des revendications 1 à 3, dans lequel chaque pavé (P1, P2, P3) présente un côté de longueur supérieure ou égale à 5 mm, de préférence supérieure ou égale à 8 mm, et de manière préférée supérieure ou égale à 10 mm.

5. Procédé selon l'une des revendications 1 à 4, dans lequel chaque puce (p11, p12, p13, p14) présente un côté de longueur inférieure ou égale à 5 mm, de préférence inférieure ou égale à 3 mm, et de manière préférée inférieure ou égale à 1 mm.

6. Procédé selon l'une des revendications 1 à 5, dans lequel la distance entre deux pavés (P1, P2, P3) adjacents est inférieure ou égale à 3 mm, de préférence inférieure ou égale à 1 mm.

7. Procédé selon l'une des revendications 1 à 6, dans lequel la distance entre deux puces (p11, p12, p13, p14) adjacentes est supérieure ou égale à 3 mm, de préférence supérieure ou égale à 5 mm.

8. Procédé selon l'une des revendications 1 à 7, dans lequel chaque pavé recouvre au moins partiellement deux zones d'intérêt distinctes du substrat receveur et on forme, à partir dudit pavé, une puce sur chaque zone d'intérêt respective.

9. Procédé selon l'une des revendications 1 à 7, dans lequel chaque pavé recouvre un coin respectif de quatre zones d'intérêt distinctes du substrat receveur agencées en carré ou en rectangle, et on forme, à partir dudit pavé, une puce sur chaque coin de la zone d'intérêt respective.

10. Procédé selon l'une des revendications 1 à 7, dans lequel chaque pavé se présente sous la forme d'une bande recouvrant au moins partiellement au moins trois zones d'intérêt alignées du substrat receveur et on forme, à partir dudit pavé, une puce sur chaque zone d'intérêt respective.

11. Procédé selon l'une des revendications 1 à 10, dans lequel le substrat support (1) et le substrat receveur (3) présentent un diamètre sensiblement identique, supérieur au diamètre du substrat donneur (2).

12. Procédé selon l'une des revendications 1 à 11, dans lequel le collage du substrat pseudo-donneur (10) sur le substrat receveur (3) est réalisé par adhésion moléculaire.

13. Procédé selon l'une des revendications 1 à 12, dans lequel le transfert de chaque portion (P'1, P'2, P'3) de pavé comprend successivement la formation d'une zone de fragilisation (11) par implantation d'espèces atomiques dans chaque pavé (P1, P2, P3) du substrat pseudo-donneur (10) pour définir une portion (P'1, P'2, P'3) de pavé à transférer, le collage du substrat pseudo-donneur (10) sur le substrat receveur (3) par l'intermédiaire des pavés (P1, P2, P3), et le détachement de chaque pavé le long de la zone de fragilisation (11).

14. Procédé selon l'une des revendications 1 à 12, dans lequel le transfert de chaque portion (P'1, P'2, P'3) de pavé comprend un amincissement par meulage et/ou gravure de chaque pavé (P1, P2, P3) du substrat pseudo-donneur.

15. Procédé selon l'une des revendications 1 à 14, dans lequel chaque pavé (P1, P2, P3) présente une épaisseur comprise entre 20 µm et 1000 µm, de préférence comprise entre 100 µm et 700 µm, et la portion transférée de chaque pavé présente une épaisseur comprise entre 30 nm et 1,5 µm.

16. Procédé selon l'une des revendications 1 à 15, dans lequel chaque pavé (P1, P2, P3) comprend :
- un matériau semi-conducteur, tel qu'un matériau III-V, notamment le nitrure d'indium (InN), le nitrure de gallium (GaN), le nitrure d'aluminium (AIN), l'arséniure d'indium (InAs), l'arséniure de gallium (GaAs), l'arséniure d'aluminium (AlAs), le phosphure d'indium (InP), le phosphure de gallium (GaP) ou le phosphure d'aluminium (AlP), ou un matériau IV ou IV-IV, notamment le germanium ou le carbure de silicium (SiC),
- un matériau piézoélectrique, tel que le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN), et/ou
- un matériau électriquement isolant, tel que le diamant, le titanate de strontium, la zircone yttriée ou le saphir.

17. Procédé selon l'une des revendications 1 à 16, comprenant une étape de formation par épitaxie d'au moins une couche épitaxiale sur chaque portion de pavé, l'enlèvement de matière pour diviser chaque portion de pavé en puces étant mis en oeuvre après ladite étape d'épitaxie.

18. Procédé selon l'une des revendications 1 à 17, dans lequel l'enlèvement de matière comprend :
- la formation d'un masque comprenant un film protecteur recouvrant en partie lesdites portions de pavés selon un motif définissant lesdites puces dans chaque portion de pavé et au moins une ouverture définissant un espace à former entre deux puces ;
- la gravure de chaque portion de pavé au travers de chaque ouverture du masque de sorte à former ledit espace pour séparer lesdites puces les unes des autres.

19. Procédé selon la revendication 18, dans lequel la gravure est réalisée au moyen d'une solution de gravure et le masque est formé d'une résine photosensible.

20. Procédé selon la revendication 18, dans lequel la gravure est réalisée au moyen d'un faisceau d'ions et le masque est formé d'un métal.

21. Procédé selon l'une des revendications 1 à 17, dans lequel l'enlèvement de matière est réalisé de manière sélective par un faisceau focalisé d'ions, ledit faisceau étant contrôlé pour balayer uniquement les régions des portions de pavés à enlever.

## Patentansprüche

1. Verfahren zur Herstellung einer Struktur, die mindestens zwei Chips (p11, p12, p13, p14) auf einem Empfangssubstrat (3) umfasst, umfassend:
- das Bilden eines Pseudodonorsubstrats (10) durch Platzieren von mindestens einem Plättchen (P1, P2, P3) mindestens eines Donorsubstrats (2) auf einem Trägersubstrat (1);
- das Kleben des Pseudodonorsubstrats (10) auf ein Empfangssubstrat (3) anhand der Plättchen, so dass jedes Plättchen mindestens teilweise mindestens zwei unterschiedliche Bereiche von Interesse (Z1, Z2, Zn) des Empfangssubstrats (3) bedeckt;
- das Übertragen eines Abschnitts (P'1, P'2, P'3) der Plättchen (P1, P2, P3) auf das Empfangssubstrat (3);
- mindestens einen Schritt des chemischmechanischen Polierens der Plättchen (P1, P2, P3) des Pseudodonorsubstrats und/oder der auf das Empfangssubstrat übertragenen Plättchenabschnitte;
- nach dem mindestens einen Schritt des chemischmechanischen Polierens ein Entfernen von Material von den Plättchenabschnitten (P'1, P'2, P'3) derart, dass jeder Plättchenabschnitt in mindestens zwei Chips (p11, p12, p13, p14) unterteilt wird, die jeweils auf einem entsprechenden Bereich von Interesse (Z1, Z2, Zn) angeordnet sind.

2. Verfahren nach Anspruch 1, wobei nach dem Ätzschritt der Bedeckungsgrad der Chips (p11, p12, p13, p14) auf dem Empfangssubstrat (3), das heißt das Verhältnis zwischen der Gesamtfläche der Chips und der Gesamtfläche des Empfangssubstrats, kleiner als 50%, vorzugsweise kleiner als 30%, ist.

3. Verfahren nach einem der Ansprüche 1 oder 2, wobei der Bedeckungsgrad der Plättchen (P1, P2, P3) auf dem Pseudodonorsubstrat (10), das heißt das Verhältnis zwischen der Gesamtfläche der Plättchen und der Gesamtfläche des Trägersubstrats, größer als 50%, vorzugsweise größer als 75%, ist.

4. Verfahren nach einem der Ansprüche 1 bis 3, wobei jedes Plättchen (P1, P2, P3) eine Seitenlänge von über oder gleich 5 mm, vorzugsweise von über oder gleich 8 mm und bevorzugt von über oder gleich 10 mm aufweist.

5. Verfahren nach einem der Ansprüche 1 bis 4, wobei jeder Chip (p11, p12, p13, p14) eine Seitenlänge von weniger als oder gleich 5 mm, vorzugsweise von weniger als oder gleich 3 mm und bevorzugt von weniger als oder gleich 1 mm aufweist.

6. Verfahren nach einem der Ansprüche 1 bis 5, wobei der Abstand zwischen zwei benachbarten Plättchen (P1, P2, P3) kleiner als oder gleich 3 mm, vorzugsweise kleiner als oder gleich 1 mm ist.

7. Verfahren nach einem der Ansprüche 1 bis 6, wobei der Abstand zwischen zwei benachbarten Chips (p11, p12, p13, p14) größer als oder gleich 3 mm, vorzugsweise größer als oder gleich 5 mm ist.

8. Verfahren nach einem der Ansprüche 1 bis 7, wobei jedes Plättchen mindestens teilweise zwei unterschiedliche Bereiche von Interesse des Empfangssubstrats bedeckt und aus dem Plättchen ein Chip auf jedem jeweiligen Bereich von Interesse gebildet wird.

9. Verfahren nach einem der Ansprüche 1 bis 7, wobei jedes Plättchen eine jeweilige Ecke von vier unterschiedlichen Bereichen von Interesse des Empfangssubstrats bedeckt, die quadratisch oder rechteckig angeordnet sind, und wobei aus dem Plättchen ein Chip an jeder Ecke des jeweiligen Bereichs von Interesse gebildet wird.

10. Verfahren nach einem der Ansprüche 1 bis 7, wobei jedes Plättchen in Form eines Streifens vorliegt, der mindestens drei ausgerichtete Bereiche von Interesse des Empfangssubstrats zumindest teilweise bedeckt, und wobei aus dem Plättchen ein Chip auf jedem jeweiligen Bereich von Interesse gebildet wird.

11. Verfahren nach einem der Ansprüche 1 bis 10, wobei das Trägersubstrat (1) und das Empfangssubstrat (3) einen im Wesentlichen identischen Durchmesser aufweisen, der größer ist als der Durchmesser des Donorsubstrats (2).

12. Verfahren nach einem der Ansprüche 1 bis 11, wobei das Kleben des Pseudodonorsubstrats (10) auf das Empfangssubstrat (3) durch molekulare Adhäsion erfolgt.

13. Verfahren nach einem der Ansprüche 1 bis 12, wobei die Übertragung jedes Plättchenabschnitts (P'1, P'2, P'3) nacheinander die Bildung einer Schwächungszone (11) durch Implantation von atomaren Spezies in jedes Plättchen (P1, P2, P3) des Pseudodonorsubstrats (10), um einen zu übertragenden Plättchenabschnitt (P'1, P'2, P'3) zu definieren, das Kleben des Pseudodonorsubstrats (10) auf das Empfangssubstrat (3) anhand der Plättchen (P1, P2, P3) und das Ablösen jedes Plättchen entlang der Schwächungszone (11) umfasst.

14. Verfahren nach einem der Ansprüche 1 bis 12, wobei die Übertragung jedes Plättchenabschnitts (P'1, P'2, P'3) eine Verschlankung durch Schleifen und/oder Ätzen jedes Plättchens (P1, P2, P3) des Pseudodonorsubstrats umfasst.

15. Verfahren nach einem der Ansprüche 1 bis 14, wobei jedes Plättchen (P1, P2, P3) eine Dicke zwischen 20 µm und 1000 µm, vorzugsweise zwischen 100 µm und 700 µm, aufweist und der übertragene Abschnitt jedes Plättchens eine Dicke zwischen 30 nm und 1,5 µm aufweist.

16. Verfahren nach einem der Ansprüche 1 bis 15, wobei jedes Plättchen (P1, P2, P3) umfasst:
- ein Halbleitermaterial, wie beispielsweise ein III-V-Material, insbesondere Indiumnitrid (InN), Galliumnitrid (GaN), Aluminiumnitrid (AlN), Indiumarsenid (InAs), Galliumarsenid (GaAs), Aluminiumarsenid (AlAs), Indiumphosphid (InP), Galliumphosphid (GaP) oder Aluminiumphosphid (AlP), oder ein IV- oder IV-IV-Material, insbesondere Germanium oder Siliziumkarbid (SiC),
- ein piezoelektrisches Material, wie beispielsweise Lithiumtantalat (LiTaO₃), Lithiumniobat (LiNbO₃), Kalium-Natrium-Niobat (KₓNa₁₋ₓNbO₃ oder KNN), Bariumtitanat (BaTiO₃), Quarz, Blei-Zirkonat-Titanat (PZT), eine Verbindung aus Blei-Magnesium-Niobat und Bleititanat (PMN-PT), Zinkoxid (ZnO), Aluminiumnitrid (AlN) oder Aluminium-Scandium-Nitrid (AlScN), und/oder
- ein elektrisch isolierendes Material wie beispielsweise Diamant, Strontiumtitanat, Yttrium-Zirkonat oder Saphir.

17. Verfahren nach einem der Ansprüche 1 bis 16, umfassend einen Schritt des Bildens mindestens einer Epitaxieschicht auf jedem Plättchenabschnitt durch Epitaxie, wobei das Entfernen von Material zum Unterteilen jedes Plättchenabschnitts in Chips nach dem Epitaxieschritt durchgeführt wird.

18. Verfahren nach einem der Ansprüche 1 bis 17, wobei das Entfernen von Material umfasst:
- das Bilden einer Maske, die einen Schutzfilm umfasst, der die Plättchenabschnitte teilweise gemäß einem Muster bedeckt, das die Chips in jedem Plättchenabschnitt und mindestens eine Öffnung definiert, die einen zwischen zwei Chips zu bildenden Zwischenraum definiert;
- das Ätzen jedes Plättchenabschnitts durch jede Öffnung der Maske derart, dass der Raum gebildet wird, um die Chips voneinander zu trennen.

19. Verfahren nach Anspruch 18, wobei das Ätzen mittels einer Ätzlösung durchgeführt wird und die Maske aus einem lichtempfindlichen Harz gebildet wird.

20. Verfahren nach Anspruch 18, wobei das Ätzen mittels eines Ionenstrahls durchgeführt wird und die Maske aus einem Metall gebildet ist.

21. Verfahren nach einem der Ansprüche 1 bis 17, wobei der Materialabtrag selektiv durch einen fokussierten Ionenstrahl durchgeführt wird, wobei der Strahl so gesteuert wird, dass er nur die Bereiche der zu entfernenden Plättchenabschnitte abtastet.

## Claims

1. Method for manufacturing a structure comprising at least two chips (p11, p12, p13, p14) on a receiving substrate (3), comprising:
- forming a pseudo-donor substrate (10) by placing at least one tile (P1, P2, P3) from at least one donor substrate (2) on a support substrate (1);
- bonding said pseudo-donor substrate (10) to a receiver substrate (3) via the tiles so that each tile at least partially covers at least two distinct areas of interest (A1, A2, A3) of the recipient substrate (3);
- transferring a portion (P'1, P'2, P'3) of said tiles (P1, P2, P3) onto the receiver substrate (3);
- at least one step of mechanochemical polishing of the tiles (P1, P2, P3) of the pseudo-donor substrate and/or portions of tiles transferred onto the receiver substrate;
- after said at least one step of mechanical-chemical polishing, removing material from said portions (P'1, P'2, P'3) of tiles so as to divide each portion of tile into at least two chips (p11, p12, p13, p14), each arranged on a respective area of interest (Z1, Z2, Zn).

2. Method according to claim 1, wherein, after the etching step, the coverage ratio of the chips (p11, p12, p13, p14) on the receiver substrate (3), i.e., the ratio between the total area of the chips and the total area of the receiver substrate, is less than 50%, preferably less than 30%.

3. Method according to one of claims 1 or 2, wherein the coverage ratio of the tiles (P1, P2, P3) on the pseudo-donor substrate (10), i.e., the ratio between the total area of the tiles and the total area of the support substrate, is greater than 50%, preferably greater than 75%.

4. Method according to one of claims 1 to 3, wherein each tile (P1, P2, P3) has a side length greater than or equal to 5 mm, preferably greater than or equal to 8 mm, and preferably greater than or equal to 10 mm.

5. Method according to one of claims 1 to 4, wherein each chip (p11, p12, p13, p14) has a side length less than or equal to 5 mm, preferably less than or equal to 3 mm, and preferably less than or equal to 1 mm.

6. Method according to one of claims 1 to 5, wherein the distance between two adjacent tiles (P1, P2, P3) is less than or equal to 3 mm, preferably less than or equal to 1 mm.

7. Method according to one of claims 1 to 6, wherein the distance between two adjacent chips (p11, p12, p13, p14) is greater than or equal to 3 mm, preferably greater than or equal to 5 mm.

8. Method according to one of claims 1 to 7, wherein each tile at least partially covers two distinct areas of interest of the receiver substrate and a chip is formed from said tile on each respective area of interest.

9. Method according to one of claims 1 to 7, wherein each tile covers a respective corner of four distinct areas of interest of the receiver substrate arranged in a square or rectangle, and a chip is formed from said tile on each corner of the respective area of interest.

10. Method according to one of claims 1 to 7, wherein each tile is in the form of a strip at least partially covering at least three aligned areas of interest of the receiving substrate, and a chip is formed from said tile on each respective area of interest.

11. Method according to one of claims 1 to 10, wherein the support substrate (1) and the receiver substrate (3) have a substantially identical diameter, greater than the diameter of the donor substrate (2).

12. Method according to one of claims 1 to 11, wherein the pseudo-donor substrate (10) is bonded to the receiver substrate (3) by molecular adhesion.

13. Method according to one of claims 1 to 12, wherein the transfer of each portion (P'1, P'2, P'3) of tile comprises successively forming a weakening zone (11) by implanting atomic species in each tile (P1, P2, P3) of the pseudo-donor substrate (10) to define a portion (P'1, P'2, P'3) of the tile to be transferred, bonding the pseudo-donor substrate (10) to the receiver substrate (3) via the tiles (P1, P2, P3), and detaching each tile along the weakening zone (11).

14. Method according to one of claims 1 to 12, wherein the transfer of each portion (P'1, P'2, P'3) of tile comprises thinning by grinding and/or etching each tile (P1, P2, P3) of the pseudo-donor substrate.

15. Method according to one of claims 1 to 14, wherein each tile (P1, P2, P3) has a thickness between 20 µm and 1000 µm, preferably between 100 µm and 700 µm, and the transferred portion of each tile has a thickness between 30 nm and 1.5 µm.

16. Method according to one of claims 1 to 15, wherein each tile (P1, P2, P3) comprises:
- a semiconductor material, such as a III-V material, in particular indium nitride (InN), gallium nitride (GaN), aluminum nitride (AIN), indium arsenide (InAs), gallium arsenide (GaAs), aluminum arsenide (AlAs), indium phosphide (InP), gallium phosphide (GaP), or aluminum phosphide (AlP), or a IV or IV-IV material, such as germanium or silicon carbide (SiC),
- a piezoelectric material, such as lithium tantalate (_{LiTaO₃}), lithium niobate (_{LiNbO₃}), potassium-sodium niobate (KₓNa₁₋ₓNbO₃ NbO₃ or KNN), barium titanate (BaTiO₃ ), quartz, lead zirconate titanate (PZT), a lead magnesium niobate-lead titanate compound (PMN-PT), zinc oxide (ZnO), aluminum nitride (AIN) or aluminum scandium nitride (AIScN), and/or
- an electrically insulating material, such as diamond, strontium titanate, yttria-stabilized zirconia, or sapphire.

17. Method according to one of claims 1 to 16, comprising a step of forming at least one epitaxial layer on each die portion by epitaxy, wherein the removal of material to divide each tile portion into chips is performed after said epitaxy step.

18. Method according to one of claims 1 to 17, wherein the removal of material comprises:
- forming a mask comprising a protective film partially covering said tile portions in a pattern defining said chips in each tile portion and at least one opening defining a space to be formed between two chips;
- etching each tile portion through each opening in the mask so as to form said space to separate said chips from each other.

19. Method according to claim 18, wherein the etching is performed using an etching solution and the mask is formed from a photosensitive resin.

20. Method according to claim 18, wherein the etching is performed using an ion beam and the mask is formed from a metal.

21. Method according to one of claims 1 to 17, wherein the removal of material is performed selectively by a focused ion beam, said beam being controlled to scan only the regions of the tile portions to be removed.
